# EUROPEAN PATENT SPECIFICATION

(11) **EP 4 199 298 B1**
(45) Date of publication and mention of the grant of the patent: **25.03.2026**
(21) Application number: 21902295.1
(22) Date of filing: 05.11.2021
(51) Int. Cl.: H02J 3/32, H02J 7/00, B60L 1/00, B60L 53/20, B60L 55/00, H01M 10/44, H01M 10/42

(54) **CHARGING AND DISCHARGING APPARATUS AND POWER TRANSMISSION METHOD THEREOF**
LADE- UND ENTLADEVORRICHTUNG UND LEISTUNGSÜBERTRAGUNGSVERFAHREN DAFÜR
APPAREIL DE CHARGE ET DE DÉCHARGE ET SON PROCÉDÉ DE TRANSMISSION DE PUISSANCE

(30) Priority: 08.12.2020 CN 202011425796
(43) Date of publication of application: 21.06.2023
(73) Proprietor: Contemporary Amperex Technology (Hong Kong) Limited, Central, Central And Western District (HK)
(72) Inventor: YE, Zhenjie, Ningde, Fujian 352100 (CN)
(74) Representative: Gong, Jinping
(86) International application number: PCT/CN2021/129136
(87) International publication number: WO 2022/121588

(56) References cited:
- EP-A1- 3 330 120
- CN-A- 106 740 168
- CN-A- 106 926 739
- CN-A- 107 069 887
- CN-A- 107 834 658
- CN-A- 108 407 625
- CN-A- 110 154 825
- CN-U- 207 719 855
- US-A1- 2018 312 072

## Description

### Technical Field

The present application relates to the field of battery power, and in particular, to a charging and discharging apparatus and a power transmission method as defined in the claim set thereof.

### Background Art

With the development of new energy, more and more fields use the new energy as power. Due to the advantages of high energy density, recyclable charging, and safety and environmental protection, batteries are widely used in power apparatuses such as electric vehicles, electric ships, and spacecrafts.

When a battery is used for charging and discharging, the battery needs to be managed and controlled by a battery management system (BMS).

However, most BMSs on the market do not support a discharging protocol. Under a condition that a BMS does not support the discharging protocol, the BMS cannot be used to discharge the battery.

CN 107 069 887 A relates to a charging and discharging system which is configured to discharge a first vehicle battery to charge a second vehicle battery using a predetermined charge handshake protocol.

### Summary of the Invention

The invention is defined by the appended claims. A charging and discharging apparatus and a power transmission method thereof provided in embodiments of the present application can implement the discharging of the battery under a condition that a BMS does not support a discharging protocol.

According to a first aspect, an embodiment of the present application provides a charging and discharging apparatus, including:
a communication module, where the communication module is communicatively connected to a battery management system (BMS) and is configured to, under a condition of being in a first energy transmission mode and the BMS not supporting a specific discharging protocol, perform first communication with the BMS based on a universal charging protocol; and
a conversion module, where one side of the conversion module is connected to a battery, the other side of the conversion module is connected to an alternating current side connecting structure, and the conversion module is configured to convert direct current provided by the battery into alternating current and transmit the alternating current to the alternating current side connecting structure in a process of the first communication,
where the first energy transmission mode is a mode in which the battery transmits power to the alternating current side connecting structure of the apparatus.

According to a second aspect, an embodiment of the present application provides a power transmission method of a charging and discharging apparatus, including:
under a condition of being in a first energy transmission mode and a battery management system (BMS) not supporting a specific discharging protocol, performing first communication with the BMS based on a universal charging protocol; and
converting direct current provided by a battery into alternating current and transmitting the alternating current to an alternating current side connecting structure in a process of the first communication,
where the first energy transmission mode is a mode in which the battery transmits power to the alternating current side connecting structure of the apparatus.

According to the charging and discharging apparatus and the power transmission method thereof in the embodiments of the present application, when the battery transmits power to the alternating current side connecting structure, a universal charging protocol may be selected to implement communication between the BMS and the charging and discharging apparatus under a condition that the BMS does not support a specific discharging protocol, so that the battery can be discharged under the condition that the BMS does not support the discharging protocol.

### Brief Description of the Drawings

In order to more clearly illustrate the technical solutions of the embodiments of the present application, the accompanying drawings to be used in the embodiments of the present application are described briefly below. For those of ordinary skill in the art, other accompanying drawings may also be obtained based on these accompanying drawings without creative efforts.
FIG. 1 is a schematic structural diagram of a charging and discharging apparatus according to an embodiment of the present application;
FIG. 2 is a schematic diagram of a power mode of a conversion module according to an embodiment of the present application;
FIG. 3 is a schematic structural diagram of an exemplary charging and discharging apparatus according to an embodiment of the present application;
FIG. 4 is a schematic flowchart of an embodiment of a power transmission method of a charging and discharging apparatus according to the present application; and
FIG. 5 is a schematic flowchart of another embodiment of a power transmission method of a charging and discharging apparatus according to the present application.

### Detailed Description of Embodiments

The following describes features and exemplary embodiments of various aspects of the present application in detail. To make the objectives, technical solutions, and advantages of the present application clearer and more comprehensible, the following further describes the present application in detail with reference to the accompanying drawings and embodiments. It should be understood that the specific embodiments described herein are merely configured to explain the present application, and are not configured to limit the present application. For those skilled in the art, the present application may be implemented in a case where some of these specific details are not required. The following description of the embodiments is merely used to provide a better understanding of the present application by illustrating examples of the present application.

It should be noted that in the specification, relational terms such as first and second are used only to distinguish one entity or operation from another entity or operation, and do not necessarily require or imply that any actual relationship or sequence exists between these entities or operations. Moreover, terms "comprise", "include", or any other variants thereof are intended to cover non-exclusive inclusion so that a process, method, article, or device that includes a series of elements not only includes these very elements, but may also include other elements not expressly listed, or also include elements inherent to this process, method, article, or device. Without being subject to further limitations, an element defined by a phrase "including ..." does not exclude presence of other identical elements in the process, method, article, or device that includes the element.

At this stage, with the development of battery technologies, usage scenarios of the battery have become increasingly wide. For example, a battery installed in an electric vehicle is taken as an example, the usage scenario of the battery installed in the electric vehicle may be referred to as a vehicle to everything (V2X) scenario. Specifically, the V2X scenario may include a grid to vehicle (G2V) scenario, a vehicle to grid (V2G) scenario, a vehicle to load (V2L) scenario, or the like.

However, in battery discharging scenarios such as the V2L or V2G, due to most of the existing BMSs not supporting a discharging protocol, the battery cannot be discharged.

Based on this, the embodiments of the present application disclose a charging and discharging apparatus and a power transmission method thereof, which may be applied to a scenario of discharging a battery. For example, they may be applied to a specific scenario where a battery is used to supply power to an alternating current load. For another example, they may be applied to a specific scenario where the battery reversely discharges to an alternating current grid. In the embodiments of the present application, under a condition that a BMS does not support a specific discharging protocol, a universal charging protocol may be used to implement communication between the BMS and the charging and discharging apparatus. Therefore, the discharging of the battery may be implemented even if the BMS does not support a specific discharging protocol. In some embodiments, the charging and discharging apparatus may be of a pile type, a wall-mounted type, a portable type, or the like, and the specific type thereof is not limited.

First, for a better understanding of the present application, the embodiments of the present application make specific description on concepts such as a battery, a BMS, a first energy transmission mode, and a second energy transmission mode.
(1) Battery. The battery in the embodiments of the present application may be a lithium-ion battery, a lithium metal battery, a lead-acid battery, a nickel-cadmium battery, a nickel-hydrogen battery, a lithium-sulfur battery, a lithium-air battery, a sodium-ion battery, or the like, which is not limited herein. In terms of scale, the battery in the embodiments of the present application may be a battery cell, or may be a battery module or a battery pack, which is not limited herein. In terms of application scenarios, the battery may be applied to power apparatuses such as cars and ships. For example, it may be applied to an electric vehicle to supply power to the motor of the electric vehicle as a power source of the electric vehicle.
(2) BMS. It has a function of collecting/calculating battery parameters, as well as a function of managing each functional module in the battery apparatus and the battery. Exemplarily, it can control an energy transmission direction of the charging and discharging apparatus, can determine whether a capacity parameter of the battery is greater than a preset threshold, can calculate the SOC, can control the on-off of a relay, and so on.
(3) The first energy transmission mode is a mode in which the battery transmits power to the alternating current side connecting structure of the charging and discharging apparatus, that is, a mode in which the battery discharges to the alternating current side connecting structure.

In some embodiments, the first energy transmission mode may be subdivided into different sub-modes based on a specific type of the alternating current side connecting structure.

The alternating current side connecting structure may be an alternating current side power supply, or an alternating current side load.

Correspondingly, the first energy transmission mode may include a first sub-mode and a second sub-mode:
The first sub-mode represents a mode in which the battery transmits power to the alternating current side power supply. Exemplarily, under a condition that the battery is a traction battery in an electric vehicle and the alternating current side power supply is a grid, the first sub-mode may be referred to as a V2G energy transmission mode, which may be referred to as V2G for short. In a V2G mode, the electric vehicle may reversely discharge to the grid by means of the charging and discharging apparatus. For example, when the electric vehicle is not running, it can be connected to the grid by means of the charging and discharging apparatus and an alternating current charging pile, and idle energy of the battery can be sold to the grid. In a G2V mode, the grid can charge the electric vehicle by means of the charging and discharging apparatus.
The second sub-mode represents a mode in which the battery transmits power to the alternating current side load. Exemplarily, under a condition that the battery is a traction battery in an electric vehicle, the second sub-mode may be referred to as a V2L energy transmission mode, which may be referred to as V2L for short.

(4) The second energy transmission mode is a mode in which the alternating current side power supply transmits power to the battery. Exemplarily, under a condition that the battery is a traction battery in an electric vehicle and the alternating current side power supply is a grid, the second energy transmission mode may be referred to as a G2V energy transmission mode, which may be referred to as G2V for short. In a G2V mode, the grid can charge the electric vehicle by means of the charging and discharging apparatus. For example, the electric vehicle can be connected to the grid by means of the charging and discharging apparatus and an alternating current charging pile, and use the grid to charge the battery.

After fully understanding the above concepts, the following parts of the embodiments of the present application will sequentially describe the charging and discharging apparatus and the power transmission method of the charging and discharging apparatus.

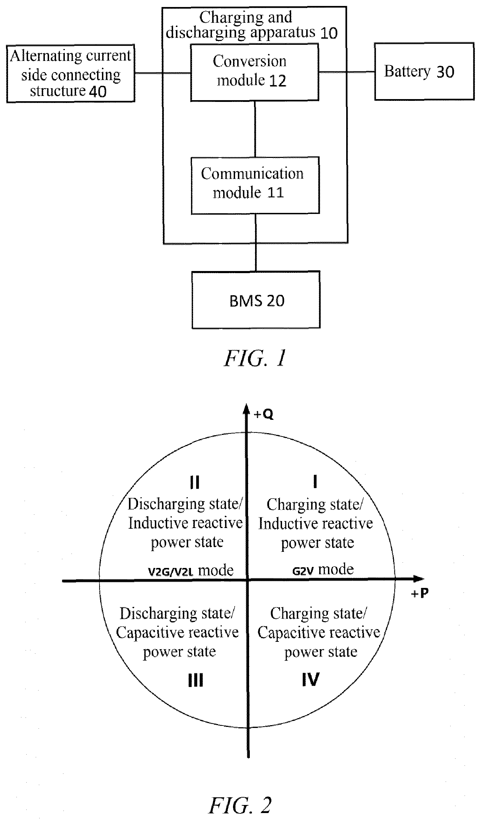

FIG. 1 is a schematic structural diagram of a charging and discharging apparatus according to an embodiment of the present application. As shown in FIG. 1, a charging and discharging apparatus 10 includes a communication module 11 and a conversion module 12.

### About the communication module 11

For a connection relationship, the communication module 11 is communicatively connected to a BMS 20. In some embodiments, controller area network (CAN) communication may be performed between the communication module 11 and the BMS 20, and a communication manner between the two is not limited.

Functionally, the communication module 11 is configured to, under a condition of being in a first energy transmission mode and the BMS 20 not supporting a specific discharging protocol, perform first communication with the BMS 20 based on a universal charging protocol.

Firstly, the universal charging protocol may refer to a charging protocol that is commonly used within a specific range and is between an electric vehicle charger and a battery management system. Exemplarily, it may be a national standard charging protocol, for example, the GB/T 27930-2015 protocol (that is, the communication protocol between the electric vehicle off-board conductive charger and the battery management system, which is carried out on January 1, 2016). It should be noted that the universal charging protocol may alternatively be a protocol of another version, which is not limited.

In some embodiments, the universal charging protocol is obtained by extending an existing universal protocol.

In one embodiment, in the process of discharging between the charging and discharging apparatus and the BMS based on the universal charging protocol, in a charging parameter configuration phase, the communication module 11 may notify the BMS 20 of a maximum input capacity of the alternating current side by means of a CML packet (that is, a packet used to notify the BMS 20 of a maximum output capacity of the charger). In addition, the BMS 20 notifies the communication module 11 of a battery discharging parameter by means of a BCP packet (that is, a packet used to notify the charger of charging parameters of a traction battery).

In one embodiment, in a charging phase, the BMS 20 may notify the communication module 11 of a battery discharging demand by means of a BLC packet (that is, a packet used to notify the charger of the battery discharging demand). The BMS 20 may further notify the communication module 11 of a total battery charging state by means of a BCS packet (that is, a packet used to notify the charger of the total battery charging state). In addition, the BMS 20 may further notify the communication module 11 that the BMS 20 suspends discharging by means of a BST packet (that is, a packet used to notify the BMS to suspend charging). In addition, the communication module 11 may further notify the BMS 20 that the communication module 11 suspends discharging by means of a CST packet (that is, a packet used to notify the charger to suspend charging).

Secondly, the specific discharging protocol may refer to a discharging protocol formulated for a discharging process between the charger and the BMS. Specifically, the specific discharging protocol may specify a physical layer, a version of a communication network, a frame format, a protocol data unit format, a network address, and a packet about phases such as a handshake phase and a discharging phase, so as to be applicable to a discharging scenario.

Thirdly, in some embodiments, the communication module 11 may first communicate with the BMS 20 based on a universal charging protocol, and then determine whether the BMS 20 supports a specific discharging protocol in the handshake phase. Specifically, the communication module 11 may determine the protocol version used by the BMS 20 based on the received vehicle handshake message (such as the BHM packet in the GB/T 27930-2015 protocol). Under a condition that the used protocol version does not include the specific discharging protocol, it is determined that the BMS 20 does not support the specific discharging protocol.

In some embodiments, the communication module 11 is further configured to:
under a condition of being in the first energy transmission mode and the BMS 20 supporting the specific discharging protocol, perform first communication with the BMS 20 based on the specific discharging protocol.

It should be noted that the first communication in the present application shall be distinguished from the second communication mentioned in subsequent sections. The first communication refers to communication in a battery discharging process, and the second communication refers to communication in a battery charging process. Specifically, under a condition that the BMS 20 does not support the specific discharging protocol, the first communication may be communication implemented on the basis of the universal charging protocol communication. Under a condition that the BMS 20 supports the specific discharging protocol, the first communication may be communication implemented on the basis of the specific discharging protocol communication.

In some embodiments, the communication module 11 is further configured to:
under a condition of being in a second energy transmission mode, perform second communication with the BMS based on a universal charging protocol. It should be noted that related description of the second communication may refer to the related description of the previous embodiment, which are not described herein again.

In some embodiments, the communication module 11 is further configured to receive an instruction sent by a user to enter an energy transmission mode. The user may select the energy transmission mode and corresponding parameters by means of a mobile phone application or an operation panel of an electronic device, and then generate an instruction based on the selected energy transmission mode and parameters.

Exemplarily, a G2V mode may be selected, and charging parameters may be selected. The charging parameters may include charging duration and/or a current charging quantity. For example, the current charging quantity may be represented by a battery capacity, or may be represented by a charging interval of a state of charge of the battery.

For another example, a V2G mode or a V2L mode may be selected, and discharging parameters may be selected. The discharging parameters may include discharging duration and/or a current discharging quantity. For example, the current discharging quantity may be represented by a battery capacity, or may be represented by a discharging interval of a state of charge of the battery.

In one example, under a condition of being in the first energy transmission mode, the communication module 11 may further calculate a maximum discharging quantity based on battery information sent by the BMS 20, then determine a smaller value between the current discharging quantity sent by the user and the calculated maximum discharging quantity, and update the smaller value to a new current discharging quantity. Through this example, it is possible to avoid over-discharge of the battery 30, thereby improving the safety and usage performance of the battery.

In another example, under a condition of being in the second energy transmission mode, the communication module 11 may further calculate a maximum charging quantity based on battery information sent by the BMS 20, then determine a smaller value between the current charging quantity sent by the user and the calculated maximum charging quantity, and update the smaller value to a new current charging quantity. Through this example, it is possible to avoid over-charge of the battery 30, thereby improving the safety and usage performance of the battery.

In one example, the communication module 11 may calculate the maximum discharging quantity or calculate the maximum charging quantity after the handshake phase and the configuration phase end, that is, after both a positive relay and a negative relay of the electric vehicle are closed.

### About the conversion module 12

For the connection relationship, one side of the conversion module 12 is connected to the battery 30, and the other side of the conversion module 12 is connected to an alternating current side connecting structure 40.

Functionally, the conversion module 12 may implement conversion between direct current and alternating current. Specifically, the conversion module 12 is configured to convert direct current provided by the battery 30 into alternating current and transmit the alternating current to the alternating current side connecting structure 40 in a process of the first communication.

For the implementation, the conversion module 12 may be implemented as a direct current-alternating current (DCAC) bidirectional conversion module. The DCAC bidirectional conversion module can convert direct current input from the direct current side into alternating current and transmit the alternating current to the alternating current side, and can also convert alternating current input from the alternating current side into direct current and transmit the direct current to the direct current side.

In one example, to implement galvanic isolation between the alternating current side connecting structure 40 and the direct current side battery 30, an isolated bidirectional full-bridge CLLC resonant circuit may be selected. It should be noted that, for the direct current output by the traction battery of the electric vehicle, its voltage may reach 200 V-500 V, while the alternating current on the alternating current side of the conversion module 12 may usually reach 220 V or 380 V, which implements the galvanic isolation on the battery and the alternating current side connecting structure from each other, and can improve the safety of power consuming devices and the safety of related personnel.

Exemplarily, the conversion module 12 may include a bidirectional full-bridge ACDC circuit part and a CLLLC DC-DC conversion circuit part, where the CLLLC DC-DC conversion circuit part uses an isolation transformer for galvanic isolation, so as to avoid mutual influence between the battery 30 and the alternating current side connecting structure 40.

The bidirectional full-bridge ACDC circuit part is mainly used for controlling the transmission of bidirectional active power and reactive power on the grid side, and implementing the four-quadrant operation of the alternating current side power. The CLLLC DC-DC conversion circuit part is mainly used for adjusting the transmission of active power on the battery side, and controlling the charging and discharging process of the battery.

In a G2V mode, active power of the conversion module 12 flows from the alternating current side to the direct current side, and the bidirectional full-bridge ACDC circuit part operates in a rectified state, which shows a step-up characteristic of a boost circuit, controls input current on the alternating current side, and stabilizes voltage on the direct current side; and the CLLLC DC-DC conversion circuit part transmits power from a primary side to a secondary side, charges the battery 30, and stabilizes output voltage or current on the battery side.

In V2G and V2L modes, the active power of the conversion module 12 flows reversely from the direct current side to the alternating current side. The bidirectional full-bridge ACDC circuit part operates in an inverse state, which shows a step-down characteristic of a buck circuit, and controls output current on the alternating current side. The CLLLC DC-DC conversion circuit transmits power from a secondary side to a primary side, discharges the battery, and stabilizes voltage on the direct current side.

In one embodiment, to improve the conversion efficiency of the conversion module 12, a bridge arm switch unit in the DCAC bidirectional conversion module may be a switch unit made of SiC materials. Alternatively, the DCAC bidirectional conversion module may implement a synchronous rectification policy.

In one embodiment, FIG. 2 is a schematic diagram of a power mode of a conversion module according to the present application. As shown in FIG. 2, in G2V, V2G, and V2L modes, the conversion module 12 operates on a P-axis. In addition, the conversion module 12 may also operate on a Q-axis in a pure reactive power mode. The conversion module 12 may simultaneously transmit active and reactive power, perform reactive power compensation and power factor correction when the battery is charging and discharging, and implement four-quadrant operation of the alternating current side in a power circle.

In some embodiments, under a condition that the alternating current side connecting structure 40 includes an alternating current side power supply and is in a second energy transmission mode, the conversion module 12 is further configured to convert alternating current provided by the alternating current side power supply into direct current and transmit the direct current to the battery 30 in a process of the second communication.

According to the charging and discharging apparatus in the embodiments of the present application, when the battery transmits power to the alternating current side connecting structure, a universal charging protocol may be selected to implement communication between the BMS and the charging and discharging apparatus under a condition that the BMS does not support a specific discharging protocol, so that the battery can be discharged under the condition that the BMS does not support the discharging protocol.

In some embodiments, the charging and discharging apparatus 10 may further include a control module 13. The following will describe the control module 13 in detail.

### About the control module 13

The control module 13 may control the conversion module 12 based on a control signal after the communication module 11 receives the control signal.

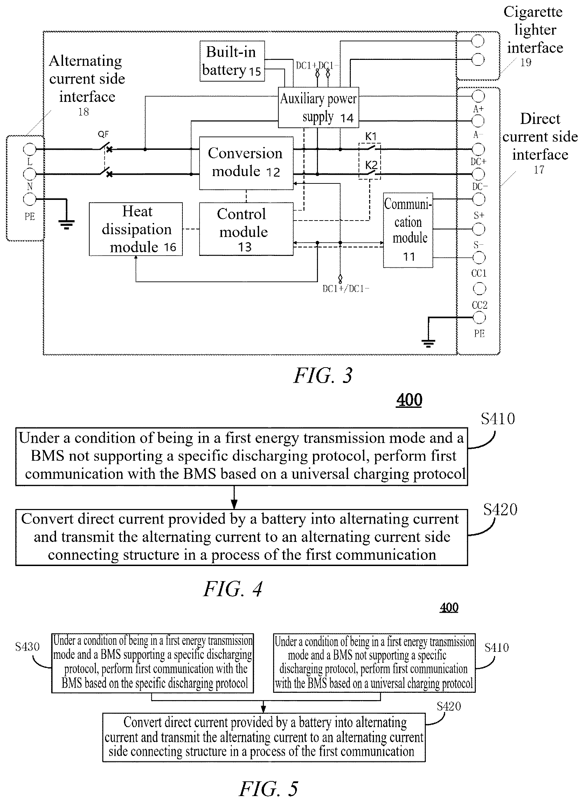

Specifically, the control module 13 may control a current conversion direction of the conversion module 12. For example, the conversion module 12 may be controlled to convert direct current to alternating current, or alternatively, the conversion module 12 may be controlled to convert alternating current to direct current. Exemplarily, FIG. 3 is a schematic structural diagram of an exemplary charging and discharging apparatus according to an embodiment of the present application. As shown in FIG. 3, the charging and discharging apparatus further includes a first switch K1 and a second switch K2, and before the conversion module 12 is controlled to start a conversion operation, the control module 13 may control the first switch K1 and the second switch K2. In addition, the first switch K1 and the second switch K2 may also be controlled to be opened after ending the charging such as ending the G2V mode, or ending the discharging such as ending the V2G mode or the V2L mode. It should be noted that the first switch K1 and the second switch K2 may be relays or semiconductor switches, and specific types of the first switch K1 and the second switch K2 are not limited.

In one embodiment, in the first energy transmission mode, the control module 13 may obtain discharging parameters by means of the communication module 11. If it is determined that the discharging parameters are reached, the control module 13 controls the conversion module 12 to stop operating. Exemplarily, under a condition that the discharging parameters include discharging duration, the control module 13 controls the conversion module 12 to stop operating after determining that the current discharging process reaches the discharging duration. For another example, if it is determined that a maximum discharging quantity is reached, the conversion module 12 is controlled to stop operating.

In addition, the control module 13 may also send a signal of ending the first energy transmission mode to the communication module 11. After receiving the signal, the communication module 11 may notify the BMS 20 to end the discharging based on a universal charging protocol or a specific discharging protocol. In addition, the communication module 11 also sends a prompt of ending the discharging to a user.

In another embodiment, in the second energy transmission mode, the control module 13 may obtain charging parameters by means of the communication module 11. If it is determined that the charging parameters are reached, the control module 13 controls the conversion module 12 to stop operating. Exemplarily, under a condition that the charging parameters include charging duration, the control module 13 controls the conversion module 12 to stop operating after determining that the current charging process reaches the charging duration. For another example, if it is determined that a current charging quantity is reached, the conversion module 12 is controlled to stop operating.

In addition, the control module 13 may also send a signal of ending the second energy transmission mode to the communication module 11. After receiving the signal, the communication module 11 may notify the BMS 20 to end the charging based on a universal charging protocol. In addition, the communication module 11 also sends a prompt of ending the charging to a user.

In one embodiment, to improve the security, in a first sub-mode, before the battery 30 is discharged to the alternating current side power supply, the control module 13 is further configured to detect whether voltage and/or voltage frequency of the alternating current side power supply is normal at an alternating current interface of the charging and discharging apparatus. In addition, under a condition that the voltage and/or the voltage frequency of the alternating current side power supply is normal, the conversion module 12 is controlled to start operating. Exemplarily, under a condition that the alternating current side power supply can be a grid, that is, the control module 13 can detect whether the voltage and the voltage frequency of the grid are anomalous, and under a condition that the voltage and the voltage frequency of the grid are anomalous, it is forbidden to start energy transmission. Exemplarily, an anomaly standard of the voltage may be that the voltage is 0, and an anomaly standard of the voltage frequency may be that the voltage frequency is 0.

Through this embodiment, electric shock to personnel caused by outputting alternating current under a condition that the alternating current side is not well connected can be avoided, and the safety of the charging and discharging apparatus is improved.

In some embodiments, to improve the security, the control module 13 is further configured to determine a current energy transmission mode, and execute a security policy corresponding to the current energy transmission mode.

Specifically, the following will describe the security policy in detail with reference to the energy transmission mode.
(1) Under a condition that the current energy transmission mode is a first sub-mode, such as a V2G mode, the security policy corresponding to the first sub-mode includes a policy A and a policy B.

The policy A is to perform insulation detection on the battery 30.

The policy B is to determine that an alternating current side voltage parameter of the charging and discharging apparatus 10 is within a preset value range.

(2) Under a condition that the current energy transmission mode is a second sub-mode, such as a V2L mode, the security policy corresponding to the second sub-mode includes:
a policy C, which is to perform insulation detection on the battery 30.

(3) Under a condition that the current energy transmission mode is a second energy transmission mode, such as a G2V mode, the security policy corresponding to the second energy transmission mode includes:
a policy D, which is to perform pre-charging on the battery 30.

In some examples, the above security policies may be implemented during a handshake phase and during parameter configuration, thereby ensuring safe electrical connection in the charging/discharging process.

In some examples, after ending the first energy transmission mode or the second energy transmission mode, discharging may be performed on the charging and discharging apparatus 10 and the battery, thereby ensuring the contact safety after power cut.

In some embodiments, to implement flexible power supply to the charging and discharging apparatus 10, the charging and discharging apparatus 10 may further include an auxiliary power supply 14. The following will describe the auxiliary power supply 14 in detail.

### About the auxiliary power supply 14

For the connection relationship, FIG. 3 is a schematic structural diagram of an exemplary charging and discharging apparatus according to an embodiment of the present application. As shown in FIG. 3, the charging and discharging apparatus may be connected to a first connection line and a second connection line. The first connection line is a line between a conversion module 12 and an alternating current side connecting structure 40. The second connection line is a line between the conversion module 12 and a battery 30. Therefore, the function of obtaining power from the alternating current side connecting structure 40 or the battery 30 may be implemented. In addition, the auxiliary power supply 14 may also be connected to a low-voltage power consuming device such as a control module 13 for supplying power to the low-voltage power consuming device.

Functionally, under a condition that the alternating current side connecting structure 40 includes an alternating current side power supply, the auxiliary power supply 14 uses alternating current provided by the alternating current side power supply to supply power to the charging and discharging apparatus 10. Optionally, the auxiliary power supply 14 may also supply power to a low-voltage power consuming device of an electric vehicle. For example, A+ and A- interfaces in a direct current side interface 17 in FIG. 3 are used to supply power to the low-voltage power consuming device of the electric vehicle.

Under a condition that the alternating current side connecting structure 40 includes an alternating current side load, the auxiliary power supply uses direct current provided by a low-voltage power supply to supply power to the charging and discharging apparatus 10 before being connected to the battery 30, and uses the direct current provided by the battery 30 to supply power to the charging and discharging apparatus 10 after being connected to the battery 30.

The low-voltage power supply includes a built-in battery 15 and/or a vehicle-mounted cigarette lighter. Exemplarily, as shown in FIG. 3, the auxiliary power supply 14 may be connected to the vehicle-mounted cigarette lighter by means of a cigarette lighter interface 19. For example, the cigarette lighter interface 19 may be implemented as a standard-compliant cigarette lighter connector. For example, the built-in battery 15 may be of a low voltage, such as 12 V.

In one embodiment, for the auxiliary power supply 14, its priorities of obtaining power may be as follows in descending order: the alternating current side power supply, the battery 30, and the low-voltage power supply. In one example, for the built-in battery 15 and the vehicle-mounted cigarette lighter in the low-voltage power supply, the priority of the built-in battery 15 may be higher than that of the vehicle-mounted cigarette lighter. Exemplarily, after a battery capacity of the built-in battery 15 is lower than a preset battery capacity threshold, power is obtained from the vehicle-mounted cigarette lighter. Whether the battery capacity of the built-in battery is too low may be determined by a battery capacity indicator light of the built-in battery 15.

It should be noted that, under a condition that the charging and discharging apparatus 10 is in a dormant state, it may be woken up by the built-in battery 15 or the vehicle-mounted cigarette lighter supplying power to it.

In some embodiments, to solve the heat dissipation problem during the operation of the charging and discharging apparatus 10, the charging and discharging apparatus 10 further includes a heat dissipation module 16.

### About the heat dissipation module 16

The heat dissipation module 16 is configured to dissipate heat for each functional module or physical structure of the charging and discharging apparatus 10, so as to ensure that heat-dissipated components operate in a suitable temperature range.

Exemplarily, the heat dissipation module 16 may be implemented as a heat dissipation structure such as a fan or a water cooling module, and a specific structure and type thereof are not limited.

Correspondingly, the heat dissipation module 16 is connected to the control module 13. The control module 13 collects a temperature of the charging and discharging apparatus 10, and if it is determined that the temperature of the charging and discharging apparatus 10 is higher than a preset temperature threshold, controls the heat dissipation module 16 to start a heat dissipation operation. Optionally, an ambient temperature of the charging and discharging apparatus 10 or temperatures of easily-heated components of the charging and discharging apparatus 10 may be collected as the temperature of the charging and discharging apparatus 10. The easily-heated components may be a switch unit of the conversion module 12, or may be a transformer.

In addition, if the temperature of the charging and discharging apparatus 10 is lower than the preset temperature threshold or after the current energy transmission mode is ended, the control module 13 further controls the heat dissipation module 16 to stop the heat dissipation operation.

In some embodiments, to be connected to the battery 30, the charging and discharging apparatus 10 further includes a direct current side interface 17.

### About the direct current side interface 17

The direct current side interface may be implemented as a direct current charging gun. Exemplarily, the direct current charging gun may be a direct current charging gun that conforms to the GB/T 18487 standard.

In one example, as shown in FIG. 3, the direct current side interface 17 may include the following interfaces:
A+ interface and A- interface: the auxiliary power supply 14 may be connected to the low-voltage power consuming device of the electric vehicle by means of the interface, so that the auxiliary power supply 14 may supply power to the low-voltage power consuming device of the electric vehicle by means of the interface. For example, the interface may supply power to the BMS 20.
DC+ interface and DC- interface: the conversion module 12 may be connected to the battery 30 by means of the interface.
S+ interface and S- interface: the communication module 11 may implement CAN communication for the BMS 20 or a user interaction terminal by means of the interface.
CC1 interface: used for detecting whether the charging gun is inserted into the electric vehicle.
CC2 interface: which is vacant.
PE interface: used for grounding.

In some embodiments, to be connected to the alternating current side connecting structure 40, the charging and discharging apparatus 10 further includes an alternating current side interface 18.

About the alternating current side interface 18.

The alternating current side interface is a standard alternating current pin plug (referred to as a male connector for short) and a standard alternating current hole plug (referred to as a female connector for short).

In one example, as shown in FIG. 3, the alternating current side interface 18 may include the following interfaces:
L interface and N interface: the conversion module 12 is connected to the alternating current side connecting structure 40 by means of the L interface and N interface.
PE interface: used for grounding.

In some embodiments, the charging and discharging apparatus 10 may further include: a third switch QF. Still referring to FIG. 3, the third switch QF may be provided on a connection line between the conversion module 12 and the alternating current side connecting structure 40. The third switch QF may control the connection or disconnection between the charging and discharging apparatus 10 and the alternating current side connecting structure 40.

After a preliminary understanding of the charging and discharging apparatus provided in the embodiments of the present application, the embodiments of the present application will describe a power transmission method of the charging and discharging apparatus provided in the embodiments of the present application in detail with reference to FIG. 4.

FIG. 4 is a schematic flowchart of an embodiment of a power transmission method of a charging and discharging apparatus according to the present application. Each step in FIG. 4 may be performed by the charging and discharging apparatus 10. As shown in FIG. 4, the power transmission method 400 of the charging and discharging apparatus may specifically include S410 to S420.

S410. Under a condition of being in a first energy transmission mode and a BMS not supporting a specific discharging protocol, first communication is performed with the BMS based on a universal charging protocol.

S420. Direct current provided by a battery is converted into alternating current and the alternating current is transmitted to an alternating current side connecting structure in a process of the first communication.

The first energy transmission mode is a mode in which the battery transmits power to the alternating current side connecting structure of the apparatus.

In some embodiments of the present application, FIG. 5 is a schematic flowchart of another embodiment of a power transmission method of a charging and discharging apparatus according to the present application. As shown in FIG. 5, the power transmission method 400 of the charging and discharging apparatus further includes S430.

S430. Under a condition of being in the first energy transmission mode and the BMS supporting the specific discharging protocol, first communication is performed with the BMS based on the specific discharging protocol.

In some embodiments of the present application, the alternating current side connecting structure is an alternating current power supply, and the power transmission method 400 of the charging and discharging apparatus further includes:
under a condition of being in a second energy transmission mode, performing second communication with the BMS based on a universal charging protocol; and converting alternating current provided by the alternating current power supply into direct current in a process of the second communication.

The second energy transmission mode is a mode in which the alternating current power supply transmits power to the battery.

In some embodiments of the present application, the universal charging protocol is obtained by extending an existing universal charging protocol.

In some embodiments of the present application, the power transmission method 400 of the charging and discharging apparatus further includes:
determining a current energy transmission mode; and
executing a security policy corresponding to the current energy transmission mode.

Under a condition that the current energy transmission mode is a first sub-mode of the first energy transmission mode, the security policy corresponding to the first sub-mode includes: performing insulation detection on the battery, and determining that an alternating current side voltage parameter of the apparatus is within a preset value range;
under a condition that the current energy transmission mode is a second sub-mode of the first energy transmission mode, the security policy corresponding to the second sub-mode includes: performing insulation detection on the battery; and
under a condition that the current energy transmission mode is the second energy transmission mode, the security policy corresponding to the second energy transmission mode includes: performing pre-charging on the battery.

The first sub-mode is a mode in which the battery transmits power to the alternating current side power supply of the apparatus.

The second sub-mode is a mode in which the battery transmits power to the alternating current side load of the apparatus.

The second energy transmission mode is a mode in which the alternating current side power supply of the apparatus transmits power to the battery.

**In** some embodiments of the present application, the power transmission method 400 of the charging and discharging apparatus further includes:
determining whether the alternating current side connecting structure of the charging and discharging apparatus includes an alternating current power supply;
under a condition that the alternating current power supply is included, using alternating current provided by the alternating current power supply to supply power to apparatus; and
under a condition that the alternating current power supply is not included, using direct current provided by an auxiliary direct current power supply to supply power to the apparatus before obtaining the direct current provided by the battery, and using the direct current provided by the battery to supply power to the apparatus after obtaining the direct current provided by the battery.

The auxiliary direct current power supply includes a power supply battery of the apparatus and/or a vehicle-mounted cigarette lighter.

According to the power transmission method of the charging and discharging apparatus in this embodiment of the present application, when the battery transmits power to the alternating current side connecting structure, a universal charging protocol may be selected to implement communication between the BMS and the charging and discharging apparatus under a condition that the BMS does not support a specific discharging protocol, so that the battery can be discharged under the condition that the BMS does not support the discharging protocol.

Other details of the power transmission method of the charging and discharging apparatus according to this embodiment of the present application are similar to those of the charging and discharging apparatus described above with reference to the examples shown in FIG. 1 to FIG. 3, and may implement its corresponding technical effects. For the brevity of description, details are not described herein again.

It should be made clear that the embodiments in this specification are described in a progressive manner, and that the same or similar parts among the embodiments can be referred to each other. Each embodiment focuses on the differences from other embodiments. The method embodiment is described in a relatively simple manner, and for related parts, refer to the description part of the system embodiment. In addition, for brevity, a detailed description of a known method technology is omitted herein.

The functional modules shown in the above embodiments may be implemented as hardware, software, firmware, or a combination thereof. Under a condition that the functional modules are implemented as hardware, the functional modules may be, for example, an electronic circuit, an application-specific integrated circuit (ASIC), appropriate firmware, a plug-in, or a function card. Under a condition that the functional modules are implemented as software, the elements of the present application are programs or code segments used to perform required tasks. The program or code segment may be stored in a machine-readable medium, or transmitted on a transmission medium or a communication link by means of a data signal carried in a carrier wave. "Machine-readable medium" may include any medium that can store or transmit information. Examples of the machine-readable storage medium may include a non-transitory computer-readable storage medium, for example, a read-only memory (ROM), a random access memory (RAM), a magnetic disk, an optical disc, or the like.

## Claims

1. A charging and discharging apparatus (10), wherein the apparatus (10) comprises:
a communication module (11), wherein the communication module (11) is communicatively connected to a battery management system, BMS, (20) and is configured to, under a condition of being in a first energy transmission mode and the BMS (20) not supporting a specific discharging protocol, perform first communication with the BMS (20) based on a universal charging protocol; and
a conversion module (12), wherein one side of the conversion module (12) is configured to be connected to a battery (30), the other side of the conversion module (12) is configured to be connected to an alternating current side connecting structure (40), and the conversion module (12) is configured to convert direct current provided by the battery (30) into alternating current and transmit the alternating current to the alternating current side connecting structure (40) in a process of the first communication,
wherein the first energy transmission mode is a mode in which the battery (30) transmits power to the alternating current side connecting structure (40) of the apparatus (10).

2. The apparatus (10) according to claim 1, wherein the communication module (11) is further configured to:
under a condition of being in the first energy transmission mode and the BMS (20) supporting the specific discharging protocol, perform first communication with the BMS (20) based on the specific discharging protocol.

3. The apparatus (10) according to claim 1, wherein the alternating current side connecting structure (40) comprises an alternating current side power supply (40);
the communication module (11) is further configured to perform second communication with the BMS (20) based on the universal charging protocol under a condition of being in a second energy transmission mode, and the second energy transmission mode is a mode in which the alternating current side power supply (40) transmits power to the battery (30); and
the conversion module (12) is further configured to convert alternating current provided by the alternating current side power supply into direct current and transmit the direct current to the battery (30) in a process of the second communication.

4. The apparatus (10) according to claim 1, wherein,
the universal charging protocol is obtained by extending an existing universal charging protocol.

5. The apparatus (10) according to claim 1, further comprising:
a control module (13) further configured to determine a current energy transmission mode; and execute a security policy corresponding to the current energy transmission mode,
wherein under a condition that the current energy transmission mode is a first sub-mode of the first energy transmission mode, the first sub-mode is a mode in which the battery (30) transmits power to an alternating current side power supply of the apparatus (10), and the security policy corresponding to the first sub-mode comprises: performing insulation detection on the battery (30), and determining that an alternating current side voltage parameter of the apparatus (10) is within a preset value range;
under a condition that the current energy transmission mode is a second sub-mode of the first energy transmission mode, the second sub-mode is a mode in which the battery (30) transmits power to an alternating current side load of the apparatus (10), and the security policy corresponding to the second sub-mode comprises: performing insulation detection on the battery (30); and
under a condition that the current energy transmission mode is a second energy transmission mode, the second energy transmission mode is a mode in which the alternating current side power supply of the apparatus (10) transmits power to the battery (30), and the security policy corresponding to the second energy transmission mode comprises: performing pre-charging on the battery (30).

6. The apparatus (10) according to claim 1, further comprising:
an auxiliary power supply (14) configured to, under a condition that the alternating current side connecting structure (40) comprises an alternating current side power supply, use alternating current provided by the alternating current side power supply to supply power to the apparatus (10); and
under a condition that the alternating current side connecting structure (40) comprises an alternating current side load, use direct current provided by a low-voltage power supply to supply power to the apparatus (10) before being connected to the battery (30), and use the direct current provided by the battery (30) to supply power to the apparatus (10) after being connected to the battery (30),
wherein the low-voltage power supply comprises a battery (15) of the apparatus **(10)** and/or a vehicle-mounted cigarette lighter.

7. A power transmission method of a charging and discharging apparatus **(10),** comprising:
under a condition of being in a first energy transmission mode and a battery management system **(BMS)** (20) not supporting a specific discharging protocol, performing first communication with the **BMS** (20) based on a universal charging protocol; and
converting direct current provided by a battery (30) into alternating current and transmitting the alternating current to an alternating current side connecting structure (40) in a process of the first communication,
wherein the first energy transmission mode is a mode in which the battery (30) transmits power to the alternating current side connecting structure (40) of the apparatus **(10).**

8. The method according to claim 7, further comprising:
under a condition of being in the first energy transmission mode and the **BMS** (20) supporting the specific discharging protocol, performing first communication with the **BMS** (20) based on the specific discharging protocol.

9. The method according to claim 7, wherein the alternating current side connecting structure (40) is an alternating current power supply (40), and
the method further comprises:
performing second communication with the **BMS** (20) based on the universal charging protocol under a condition of being in a second energy transmission mode, wherein the second energy transmission mode is a mode in which the alternating current power supply (40) transmits power to the battery (30); and
converting alternating current provided by the alternating current power supply (40) into direct current in a process of the second communication.

10. The method according to claim 7, wherein
the universal charging protocol is obtained by extending an existing universal charging protocol.

11. The method according to claim 7, wherein the method further comprises:
determining a current energy transmission mode; and
executing a security policy corresponding to the current energy transmission mode,
wherein under a condition that the current energy transmission mode is a first sub-mode of the first energy transmission mode, the first sub-mode is a mode in which the battery (30) transmits power to an alternating current side power supply of the apparatus (10), and the security policy corresponding to the first sub-mode comprises: performing insulation detection on the battery (30), and determining that an alternating current side voltage parameter of the apparatus (10) is within a preset value range;
under a condition that the current energy transmission mode is a second sub-mode of the first energy transmission mode, the second sub-mode is a mode in which the battery (30) transmits power to an alternating current side load of the apparatus (10), and the security policy corresponding to the second sub-mode comprises: performing insulation detection on the battery (30); and
under a condition that the current energy transmission mode is a second energy transmission mode, the second energy transmission mode is a mode in which the alternating current side power supply of the apparatus (10) transmits power to the battery (30), and the security policy corresponding to the second energy transmission mode comprises: performing pre-charging on the battery (30).

12. The method according to claim 7, further comprising:
determining whether the alternating current side connecting structure (40) of the charging and discharging apparatus comprises an alternating current power supply (40);
under a condition that the alternating current power supply (40) is comprised, using alternating current provided by the alternating current power supply (40) to supply power to the apparatus (10); and
under a condition that the alternating current power supply (40) is not comprised, using direct current provided by an auxiliary direct current power supply to supply power to the apparatus (10) before obtaining the direct current provided by the battery (30), and using the direct current provided by the battery (30) to supply power to the apparatus (10) after obtaining the direct current provided by the battery (30),
wherein the auxiliary direct current power supply comprises a power supply battery of the apparatus (10) and/or a vehicle-mounted cigarette lighter.

13. A computer program product, wherein the computer program product is executable to cause a charging and discharging apparatus (10) to implement the steps of a power transmission method according to any one of claims 7 to 12.

## Patentansprüche

1. Lade- und Entladeeinrichtung (10), wobei die Einrichtung (10) Folgendes umfasst:
ein Kommunikationsmodul (11), wobei das Kommunikationsmodul (11) kommunikativ mit einem Batteriemanagementsystem, BMS, (20), verbunden ist und konfiguriert ist, unter einer Bedingung, dass es sich in einem ersten Energieübertragungsmodus befindet und das BMS (20) kein spezifisches Entladeprotokoll unterstützt, eine erste Kommunikation mit dem BMS (20) basierend auf einem universellen Ladeprotokoll durchzuführen; und
ein Umwandlungsmodul (12), wobei eine Seite des Umwandlungsmoduls (12) konfiguriert ist, mit einer Batterie (30) verbunden zu sein, die andere Seite des Umwandlungsmoduls (12) konfiguriert ist, mit einer wechselstromseitigen Verbindungsstruktur (40) verbunden zu sein, und das Umwandlungsmodul (12) konfiguriert ist, einen von der Batterie (30) bereitgestellten Gleichstrom in Wechselstrom umzuwandeln und den Wechselstrom in einem Prozess der ersten Kommunikation an die wechselstromseitige Verbindungsstruktur (40) zu übertragen,
wobei der erste Energieübertragungsmodus ein Modus ist, in dem die Batterie (30) Leistung an die wechselstromseitige Verbindungsstruktur (40) der Einrichtung (10) überträgt.

2. Einrichtung (10) nach Anspruch 1, wobei das Kommunikationsmodul (11) ferner konfiguriert ist zum:
unter einer Bedingung, dass es sich im ersten Energieübertragungsmodus befindet und das BMS (20) das spezifische Entladeprotokoll unterstützt, Durchführen der ersten Kommunikation mit dem BMS (20) basierend auf dem spezifischen Entladeprotokoll.

3. Einrichtung (10) nach Anspruch 1, wobei die wechselstromseitige Verbindungsstruktur (40) eine wechselstromseitige Leistungsversorgung (40) umfasst;
wobei das Kommunikationsmodul (11) ferner konfiguriert ist, eine zweite Kommunikation mit dem BMS (20) basierend auf dem universellen Ladeprotokoll unter einer Bedingung durchzuführen, dass es sich in einem zweiten Energieübertragungsmodus befindet, und der zweite Energieübertragungsmodus ein Modus ist, in dem die wechselstromseitige Leistungsversorgung (40) Leistung an die Batterie (30) überträgt; und
wobei das Umwandlungsmodul (12) ferner konfiguriert ist, von der wechselstromseitigen Leistungsversorgung bereitgestellten Wechselstrom in Gleichstrom umzuwandeln und den Gleichstrom in einem Prozess der zweiten Kommunikation an die Batterie (30) zu übertragen.

4. Einrichtung (10) nach Anspruch 1, wobei
das universelle Ladeprotokoll durch die Erweiterung eines bestehenden universellen Ladeprotokolls erhalten wird.

5. Einrichtung (10) nach Anspruch 1, die ferner Folgendes umfasst:
ein Steuermodul (13), das ferner konfiguriert ist, einen aktuellen Energieübertragungsmodus zu bestimmen und eine dem aktuellen Energieübertragungsmodus entsprechende Sicherheitsrichtlinie auszuführen,
wobei unter einer Bedingung, dass der aktuelle Energieübertragungsmodus ein erster Untermodus des ersten Energieübertragungsmodus ist, der erste Untermodus ein Modus ist, in dem die Batterie (30) Leistung an eine wechselstromseitige Leistungsversorgung der Einrichtung (10) überträgt, und die dem ersten Untermodus entsprechende Sicherheitsrichtlinie umfasst: Durchführen einer Isolationsdetektion an der Batterie (30) und Bestimmen, dass ein wechselstromseitiger Spannungsparameter der Einrichtung (10) innerhalb eines voreingestellten Wertebereichs liegt;
unter einer Bedingung, dass der aktuelle Energieübertragungsmodus ein zweiter Untermodus des ersten Energieübertragungsmodus ist, der zweite Untermodus ein Modus ist, in dem die Batterie (30) Leistung an eine wechselstromseitige Last der Einrichtung (10) überträgt, und die dem zweiten Untermodus entsprechende Sicherheitsrichtlinie umfasst: Durchführen einer Isolationsdetektion an der Batterie (30); und
unter einer Bedingung, dass der aktuelle Energieübertragungsmodus ein zweiter Energieübertragungsmodus ist, der zweite Energieübertragungsmodus ein Modus ist, in dem die wechselstromseitige Leistungsversorgung der Einrichtung (10) Leistung an die Batterie (30) überträgt, und die dem zweiten Energieübertragungsmodus entsprechende Sicherheitsrichtlinie umfasst: Durchführen einer Vorladung an der Batterie (30).

6. Einrichtung (10) nach Anspruch 1, die ferner Folgendes umfasst:
eine Hilfsleistungsversorgung (14), die konfiguriert ist, unter einer Bedingung, dass die wechselstromseitige Verbindungsstruktur (40) eine wechselstromseitige Leistungsversorgung umfasst, von der wechselstromseitigen Leistungsversorgung bereitgestellten Wechselstrom zu verwenden, um die Einrichtung (10) mit Leistung zu versorgen, und
unter einer Bedingung, dass die wechselstromseitige Verbindungsstruktur (40) eine wechselstromseitige Last umfasst, den von einer Niederspannungs-Leistungsversorgung bereitgestellten Gleichstrom zu verwenden, um die Einrichtung (10) mit Leistung zu versorgen, bevor sie mit der Batterie (30) verbunden wird, und den von der Batterie (30) bereitgestellten Gleichstrom zu verwenden, um die Einrichtung (10) mit Leistung zu versorgen, nachdem sie mit der Batterie (30) verbunden wird,
wobei die Niederspannungs-Leistungsversorgung eine Batterie (15) der Einrichtung (10) und/oder einen an einem Fahrzeug montierten Zigarettenanzünder umfasst.

7. Verfahren zur Leistungsübertragung einer Lade- und Entladeeinrichtung (10), das Folgendes umfasst:
unter einer Bedingung, dass sie sich in einem ersten Energieübertragungsmodus befindet und ein Batteriemanagementsystem (BMS) (20) kein spezifisches Entladeprotokoll unterstützt, Durchführen einer ersten Kommunikation mit dem BMS (20) basierend auf einem universellen Ladeprotokoll; und
Umwandeln von Gleichstrom, der von einer Batterie (30) bereitgestellt wird, in Wechselstrom und Übertragen des Wechselstroms an eine wechselstromseitige Verbindungsstruktur (40) in einem Prozess der ersten Kommunikation,
wobei der erste Energieübertragungsmodus ein Modus ist, in dem die Batterie (30) Leistung an die wechselstromseitige Verbindungsstruktur (40) der Einrichtung (10) überträgt.

8. Verfahren nach Anspruch 7, das ferner Folgendes umfasst:
unter einer Bedingung, dass es sich im ersten Energieübertragungsmodus befindet und das BMS (20) das spezifische Entladeprotokoll unterstützt, Durchführen der ersten Kommunikation mit dem BMS (20) basierend auf dem spezifischen Entladeprotokoll.

9. Verfahren nach Anspruch 7, wobei die wechselstromseitige Verbindungsstruktur (40) eine Wechselstrom-Leistungsversorgung (40) ist, und
das Verfahren ferner Folgendes umfasst:
Durchführen einer zweiten Kommunikation mit dem BMS (20) basierend auf dem universellen Ladeprotokoll unter einer Bedingung durchzuführen, dass es sich in einem zweiten Energieübertragungsmodus befindet, wobei der zweite Energieübertragungsmodus ein Modus ist, in dem die Wechselstrom-Leistungsversorgung (40) Leistung an die Batterie (30) überträgt; und
Umwandeln von Wechselstrom, der von der Wechselstrom-Leistungsversorgung (40) bereitgestellt wird, in Gleichstrom in einem Prozess der zweiten Kommunikation.

10. Verfahren nach Anspruch 7, wobei
das universelle Ladeprotokoll durch die Erweiterung eines bestehenden universellen Ladeprotokolls erhalten wird.

11. Verfahren nach Anspruch 7, wobei das Verfahren ferner Folgendes umfasst:
Bestimmen eines aktuellen Energieübertragungsmodus; und
Ausführen einer Sicherheitsrichtlinie, die dem aktuellen Energieübertragungsmodus entspricht, wobei unter einer Bedingung, dass der aktuelle Energieübertragungsmodus ein erster Untermodus des ersten Energieübertragungsmodus ist, der erste Untermodus ein Modus ist, in dem die Batterie (30) Leistung an eine wechselstromseitige Leistungsversorgung der Einrichtung (10) überträgt, und die dem ersten Untermodus entsprechende Sicherheitsrichtlinie umfasst: Durchführen einer Isolationsdetektion an der Batterie (30) und Bestimmen, dass ein wechselstromseitiger Spannungsparameter der Einrichtung (10) innerhalb eines voreingestellten Wertebereichs liegt;
unter einer Bedingung, dass der aktuelle Energieübertragungsmodus ein zweiter Untermodus des ersten Energieübertragungsmodus ist, der zweite Untermodus ein Modus ist, in dem die Batterie (30) Leistung an eine wechselstromseitige Last der Einrichtung (10) überträgt, und die dem zweiten Untermodus entsprechende Sicherheitsrichtlinie umfasst: Durchführen einer Isolationsdetektion an der Batterie (30); und
unter einer Bedingung, dass der aktuelle Energieübertragungsmodus ein zweiter Energieübertragungsmodus ist, der zweite Energieübertragungsmodus ein Modus ist, in dem die wechselstromseitige Leistungsversorgung der Einrichtung (10) Leistung an die Batterie (30) überträgt, und die dem zweiten Energieübertragungsmodus entsprechende Sicherheitsrichtlinie umfasst: Durchführen einer Vorladung an der Batterie (30).

12. Verfahren nach Anspruch 7, das ferner Folgendes umfasst:
Bestimmen, ob die wechselstromseitige Verbindungsstruktur (40) der Lade- und Entladeeinrichtung eine Wechselstrom-Leistungsversorgung (40) umfasst;
unter einer Bedingung, dass die Wechselstrom-Leistungsversorgung (40) enthalten ist, Verwenden von Wechselstrom, der von der Wechselstrom-Leistungsversorgung (40) bereitgestellt wird, um die Einrichtung (10) mit Leistung zu versorgen; und
unter einer Bedingung, dass die Wechselstrom-Leistungsversorgung (40) nicht enthalten ist, Verwenden von Gleichstrom, der von einer Hilfsgleichstrom-Leistungsversorgung bereitgestellt wird, um die Einrichtung (10) mit Leistung zu versorgen, bevor der von der Batterie (30) bereitgestellte Gleichstrom erhalten wird, und Verwenden des von der Batterie (30) bereitgestellten Gleichstroms, um die Einrichtung (10) mit Leistung zu versorgen, nachdem der von der Batterie (30) bereitgestellte Gleichstrom erhalten wird,
wobei die Hilfsgleichstrom-Leistungsversorgung eine Leistungsversorgungsbatterie der Einrichtung (10) und/oder einen an einem Fahrzeug montierten Zigarettenanzünder umfasst.

13. Computerprogrammprodukt, wobei das Computerprogrammprodukt ausführbar ist, um eine Lade- und Entladeeinrichtung (10) zu veranlassen, die Schritte eines Leistungsübertragungsverfahrens nach einem der Ansprüche 7 bis 12 zu implementieren.

## Revendications

1. Appareil de charge et de décharge (10), l'appareil (10) comprenant :
un module de communication (11), le module de communication (11) étant connecté en communication avec un système de gestion de batterie, BMS, (20) et étant configuré pour, dans le cas où un premier mode de transmission d'énergie est actif et où le BMS (20) ne prend pas en charge un protocole de décharge spécifique, réaliser une première communication avec le BMS (20) sur la base d'un protocole de charge universel ; et
un module de conversion (12), un côté du module de conversion (12) étant configuré pour être connecté à une batterie (30), l'autre côté du module de conversion (12) étant configuré pour être connecté à une structure de connexion côté courant alternatif (40), et le module de conversion (12) étant configuré pour convertir un courant continu fourni par la batterie (30) en un courant alternatif et transmettre le courant alternatif à la structure de connexion côté courant alternatif (40) au cours de la première communication,
dans lequel le premier mode de transmission d'énergie est un mode dans lequel la batterie (30) transmet de la puissance à la structure de connexion côté courant alternatif (40) de l'appareil (10).

2. Appareil (10) selon la revendication 1, dans lequel le module de communication (11) est configuré en outre pour :
dans le cas où le premier mode de transmission d'énergie est actif et où le BMS (20) prend en charge le protocole de décharge spécifique, réaliser une première communication avec le BMS (20) sur la base du protocole de décharge spécifique.

3. Appareil (10) selon la revendication 1, dans lequel la structure de connexion côté courant alternatif (40) comprend une alimentation électrique côté courant alternatif (40) ;
le module de communication (11) est configuré en outre pour réaliser une deuxième communication avec le BMS (20) sur la base du protocole de charge universel dans le cas où un deuxième mode de transmission d'énergie est actif, et le deuxième mode de transmission d'énergie est un mode dans lequel l'alimentation électrique côté courant alternatif (40) transmet de la puissance à la batterie (30) ; et
le module de conversion (12) est en outre configuré pour convertir un courant alternatif fourni par l'alimentation électrique côté courant alternatif en un courant continu et transmettre le courant continu à la batterie (30) au cours de la deuxième communication.

4. Appareil (10) selon la revendication 1, dans lequel
le protocole de charge universel est obtenu par extension d'un protocole de charge universel existant.

5. Appareil (10) selon la revendication 1, comprenant en outre :
un module de commande (13) configuré en outre pour déterminer un mode de transmission d'énergie en cours ; et exécuter une politique de sécurité correspondant au mode de transmission d'énergie en cours,
dans lequel dans le cas où le mode de transmission d'énergie en cours est un premier sous-mode du premier mode de transmission d'énergie, le premier sous-mode est un mode dans lequel la batterie (30) transmet de la puissance à une alimentation électrique côté courant alternatif de l'appareil (10), et la politique de sécurité correspondant au premier sous-mode comprend : la réalisation d'une détection d'isolation sur la batterie (30), et la détermination qu'un paramètre de tension côté courant alternatif de l'appareil (10) s'inscrit dans une plage de valeurs prédéfinie ;
dans le cas où le mode de transmission d'énergie en cours est un deuxième sous-mode du premier mode de transmission d'énergie, le deuxième sous-mode est un mode dans lequel la batterie (30) transmet de la puissance à une charge côté courant alternatif de l'appareil (10), et la politique de sécurité correspondant au deuxième sous-mode comprend : la réalisation d'une détection d'isolation sur la batterie (30) ; et
dans le cas où le mode de transmission d'énergie en cours est un deuxième mode de transmission d'énergie, le deuxième mode de transmission d'énergie est un mode dans lequel l'alimentation électrique côté courant alternatif de l'appareil (10) transmet de la puissance à la batterie (30), et la politique de sécurité correspondant au deuxième mode de transmission d'énergie comprend : la réalisation d'une précharge sur la batterie (30).

6. Appareil (10) selon la revendication 1, comprenant en outre :
une alimentation électrique auxiliaire (14) configurée pour, dans le cas où la structure de connexion côté courant alternatif (40) comprend une alimentation électrique côté courant alternatif, utiliser un courant alternatif fourni par l'alimentation électrique côté courant alternatif pour alimenter électriquement l'appareil (10) ; et
dans le cas où la structure de connexion côté courant alternatif (40) comprend une charge côté courant alternatif, utiliser un courant continu fourni par une alimentation électrique basse tension pour alimenter électriquement l'appareil (10) avant la connexion à la batterie (30), et utiliser le courant continu fourni par la batterie (30) pour alimenter électriquement l'appareil (10) après la connexion à la batterie (30),
dans lequel l'alimentation électrique basse tension comprend une batterie (15) de l'appareil (10) et/ou un allume-cigare monté sur véhicule.

7. Procédé de transmission de puissance d'un appareil de charge et de décharge (10), comprenant :
dans le cas où un premier mode de transmission d'énergie est actif et où un système de gestion de batterie (BMS) (20) ne prend pas en charge un protocole de décharge spécifique, la réalisation d'une première communication avec le BMS (20) sur la base d'un protocole de charge universel ; et
la conversion d'un courant continu fourni par une batterie (30) en un courant alternatif et la transmission du courant alternatif à une structure de connexion côté courant alternatif (40) au cours de la première communication,
dans lequel le premier mode de transmission d'énergie est un mode dans lequel la batterie (30) transmet de la puissance à la structure de connexion côté courant alternatif (40) de l'appareil (10).

8. Procédé selon la revendication 7, comprenant en outre :
dans le cas où le premier mode de transmission d'énergie est actif et où le BMS (20) prend en charge le protocole de décharge spécifique, la réalisation d'une première communication avec le BMS (20) sur la base du protocole de décharge spécifique.

9. Procédé selon la revendication 7, dans lequel la structure de connexion côté courant alternatif (40) est une alimentation électrique en courant alternatif (40), et
le procédé comprenant en outre :
la réalisation d'une deuxième communication avec le BMS (20) sur la base du protocole de charge universel dans le cas où un deuxième mode de transmission d'énergie est actif, le deuxième mode de transmission d'énergie étant un mode dans lequel l'alimentation électrique en courant alternatif (40) transmet de la puissance à la batterie (30) ; et
la conversion d'un courant alternatif fourni par l'alimentation électrique en un courant alternatif (40) en courant continu au cours de la deuxième communication.

10. Procédé selon la revendication 7, dans lequel
le protocole de charge universel est obtenu par extension d'un protocole de charge universel existant.

11. Procédé selon la revendication 7, le procédé comprenant en outre :
la détermination d'un mode de transmission d'énergie en cours ; et
l'exécution d'une politique de sécurité correspondant au mode de transmission d'énergie en cours, dans lequel dans le cas où le mode de transmission d'énergie en cours est un premier sous-mode du premier mode de transmission d'énergie, le premier sous-mode est un mode dans lequel la batterie (30) transmet de la puissance à une alimentation électrique côté courant alternatif de l'appareil (10), et la politique de sécurité correspondant au premier sous-mode comprend : la réalisation d'une détection d'isolation sur la batterie (30), et la détermination qu'un paramètre de tension côté courant alternatif de l'appareil (10) s'inscrit dans une plage de valeurs prédéfinie ;
dans le cas où le mode de transmission d'énergie en cours est un deuxième sous-mode du premier mode de transmission d'énergie, le deuxième sous-mode est un mode dans lequel la batterie (30) transmet de la puissance à une charge côté courant alternatif de l'appareil (10), et la politique de sécurité correspondant au deuxième sous-mode comprend : la réalisation d'une détection d'isolation sur la batterie (30) ; et
dans le cas où le mode de transmission d'énergie en cours est un deuxième mode de transmission d'énergie, le deuxième mode de transmission d'énergie est un mode dans lequel l'alimentation électrique côté courant alternatif de l'appareil (10) transmet de la puissance à la batterie (30), et la politique de sécurité correspondant au deuxième mode de transmission d'énergie comprend : la réalisation d'une précharge sur la batterie (30).

12. Procédé selon la revendication 7, comprenant en outre :
la détermination si la structure de connexion côté courant alternatif (40) de l'appareil de charge et de décharge comprend ou non une alimentation électrique en courant alternatif (40) ;
dans le cas où l'alimentation électrique en courant alternatif (40) est comprise, l'utilisation d'un courant alternatif fourni par l'alimentation électrique en courant alternatif (40) pour alimenter électriquement l'appareil (10) ; et
dans le cas où l'alimentation électrique en courant alternatif (40) n'est pas comprise, l'utilisation d'un courant continu fourni par une alimentation électrique en courant continu auxiliaire pour alimenter électriquement l'appareil (10) avant l'obtention du courant continu fourni par la batterie (30), et l'utilisation du courant continu fourni par la batterie (30) pour alimenter électriquement l'appareil (10) après l'obtention du courant continu fourni par la batterie (30),
dans lequel l'alimentation électrique en courant continu auxiliaire comprend une batterie d'alimentation électrique de l'appareil (10) et/ou un allume-cigare monté sur véhicule.

13. Produit programme d'ordinateur, le produit de programme d'ordinateur étant exécutable pour amener un appareil de charge et de décharge (10) à mettre en œuvre les étapes d'un procédé de transmission de puissance selon l'une quelconque des revendications 7 à 12.
